# FASCICULE DE BREVET EUROPEEN

(11) **EP 4 427 260 B1**
(45) Date de publication et mention de la délivrance du brevet: **03.12.2025**
(21) Numéro de dépôt: 22802651.4
(22) Date de dépôt: 20.10.2022
(51) Int. Cl.: H01L 21/02, H01L 21/308

(54) **PROCEDE DE TRAITEMENT DE SURFACE**
OBERFLÄCHENBEHANDLUNGSVERFAHREN
SURFACE TREATMENT METHOD

(30) Priorité: 02.11.2021 FR 2111606
(43) Date de publication de la demande: 11.09.2024
(73) Titulaire: Commissariat à l'Energie Atomique et aux Energies Alternatives, 75015 Paris (FR)
(72) Inventeur: DUPRE, Ludovic, 38054 GRENOBLE CEDEX 09 (FR); FOURNIER, Hélène, 38054 GRENOBLE CEDEX 09 (FR)
(74) Mandataire: INNOV-GROUP
(86) Numéro de dépôt international: PCT/EP2022/079302
(87) Numéro de publication internationale: WO 2023/078692

(56) Documents cités:
- EP-A1- 3 608 944
- US-A1- 2005 186 800
- US-A1- 2020 381 250

## Description

### Domaine technique

L'invention se rapporte au domaine technique des procédés de traitement de surface. L'invention trouve notamment son application dans la suppression de cristallites pouvant apparaître lors d'une épitaxie sélective sur un substrat (SAG pour *« Selective Area Growth* » en langue anglaise).

### État de l'art

Un procédé de traitement de surface connu de l'état de la technique, appelé « *Etch back* » en langue anglaise, consiste à déposer une couche d'aplanissement, réalisée en polymère, sur un substrat présentant une forte topographie de surface (i.e. non plane), telle qu'une surface structurée formant des motifs (relief). Les zones de la couche d'aplanissement, faisant face aux parties supérieures des motifs, sont retirées par amincissement de la couche d'aplanissement (e.g. gravure) de manière à exposer les parties supérieures des motifs. Puis les motifs sont retirés par une gravure plasma.

Un tel procédé de l'état de la technique n'est pas entièrement satisfaisant dans la mesure où l'efficacité de la gravure plasma est fortement dépendante :
- de la géométrie des motifs, notamment de l'inclinaison des flancs des motifs par rapport à la normale à la surface du substrat, et
- de la disparité de taille des motifs à la surface du substrat.

En particulier, lorsque les motifs possèdent une partie inférieure présentant une étendue latérale supérieure à celle de la partie supérieure exposée, la gravure plasma ne peut pas retirer en totalité les motifs. En effet, les portions latérales de la partie inférieure des motifs, s'étendant au-delà de la partie supérieure exposée, demeurent après la gravure plasma.

EP 3 608 944 A1 divulgue un traitement de surface permettant la suppression d'amas de matière d'un matériau pouvant apparaître lors d'une épitaxie sélective dudit matériau sur un substrat.

### Exposé de l'invention

L'invention vise à remédier en tout ou partie aux inconvénients précités. A cet effet, l'invention a pour objet un procédé de traitement de surface, comportant les étapes :
a) prévoir un substrat comportant une surface présentant :
   - des zones d'épitaxie sélective d'un premier matériau,
   - des amas de matière du premier matériau, s'étendant entre les zones d'épitaxie sélective ;
b) former une couche de protection, réalisée dans un deuxième matériau, sur la surface du substrat de manière à recouvrir les zones d'épitaxie sélective et les amas de matière ;
c) former une couche d'aplanissement sur la couche de protection ;
d) retirer des zones de la couche d'aplanissement faisant face aux amas de matière de manière à exposer des zones supérieures de la couche de protection s'étendant sur les amas de matière ;
e) graver, par une gravure chimique humide, les zones supérieures exposées de la couche de protection ainsi que des zones latérales de la couche de protection s'étendant en bordure des amas de matière, la gravure chimique humide étant exécutée par un agent de gravure autorisant une gravure sélective du deuxième matériau par rapport au premier matériau ;
f) retirer la couche d'aplanissement ;
g) graver les amas de matière, la couche de protection étant adaptée pour former un masque de gravure protégeant les zones d'épitaxie sélective ;
h) retirer la couche de protection.

Ainsi, un tel procédé selon l'invention permet de supprimer totalement les amas de matière, quelles que soient leur géométrie (en particulier avec des flancs inclinés) et leur disparité de taille. En effet, l'étape e) permet, par la gravure chimique humide, de dégager les bordures des amas de matière en supprimant les zones latérales de la couche de protection. Ce dégagement préalable des bordures des amas de matière permet de graver totalement les amas de matière lors de l'étape g), par exemple par une gravure plasma.

En outre, la couche de protection permet de protéger les zones d'épitaxie sélective :
(i) lors de l'étape e) car la gravure chimique humide est exécutée par un agent de gravure autorisant une gravure sélective du deuxième matériau par rapport au premier matériau,
(ii) lors de l'étape g) car la couche de protection forme un masque de gravure. Autrement dit, la couche de protection autorise lors de l'étape g) une gravure sélective du premier matériau par rapport au deuxième matériau.

L'invention a également pour objet un procédé de traitement de surface, comportant les étapes :
a) prévoir un substrat comportant une surface présentant :
   - des zones d'épitaxie sélective d'un premier matériau,
   - des amas de matière du premier matériau, s'étendant entre les zones d'épitaxie sélective ;
b) former une couche de protection, réalisée dans un deuxième matériau, sur la surface du substrat de manière à recouvrir les zones d'épitaxie sélective et les amas de matière ;
c) former une couche d'aplanissement sur la couche de protection ;
d') retirer des zones de la couche d'aplanissement faisant face aux amas de matière ainsi que des zones supérieures de la couche de protection s'étendant sur les amas de matière, de manière à exposer les amas de matière ;
e') graver, par une gravure chimique humide, des zones latérales de la couche de protection s'étendant en bordure des amas de matière exposés, la gravure chimique humide étant exécutée par un agent de gravure autorisant une gravure sélective du deuxième matériau par rapport au premier matériau ;
f) retirer la couche d'aplanissement ;
g) graver les amas de matière, la couche de protection formant un masque de gravure protégeant les zones d'épitaxie sélective ;
h) retirer la couche de protection.

Ainsi, comme évoqué précédemment, un tel procédé selon l'invention permet de supprimer totalement les amas de matière, quelles que soient leur géométrie (en particulier avec des flancs inclinés) et leur disparité de taille. En effet, l'étape e') permet, par la gravure chimique humide, de dégager les bordures des amas de matière en supprimant les zones latérales de la couche de protection. Ce dégagement préalable des bordures des amas de matière permet de graver totalement les amas de matière lors de l'étape g), par exemple par une gravure plasma.

En outre, la couche de protection permet de protéger les zones d'épitaxie sélective :
(i) lors de l'étape e') car la gravure chimique humide est exécutée par un agent de gravure autorisant une gravure sélective du deuxième matériau par rapport au premier matériau,
(ii) lors de l'étape g) car la couche de protection forme un masque de gravure. Autrement dit, la couche de protection autorise lors de l'étape g) une gravure sélective du premier matériau par rapport au deuxième matériau.

L'étape d') diffère de l'étape d) en ce que les zones supérieures de la couche de protection sont retirées en même temps (i.e. lors d'une même gravure) que les zones de la couche d'aplanissement faisant face aux amas de matière. L'étape e') diffère de l'étape e) en ce que seules les zones latérales de la couche de protection, s'étendant en bordure des amas de matière, sont gravées par la gravure chimique humide.

Le procédé selon l'invention peut comporter une ou plusieurs des caractéristiques suivantes.

Selon une caractéristique de l'invention, la couche d'aplanissement est réalisée dans un troisième matériau ; et l'étape d) est exécutée par une gravure sélective du troisième matériau par rapport au deuxième matériau, la gravure étant de préférence une gravure plasma.

Ainsi, un avantage procuré est de retirer efficacement les zones de la couche d'aplanissement, faisant face aux amas de matière, de manière à exposer des zones supérieures de la couche de protection s'étendant sur les amas de matière tout en gardant protégées les zones d'épitaxie sélective.

Selon une caractéristique de l'invention, la couche d'aplanissement est réalisée dans un troisième matériau ; et l'étape d') est exécutée par une gravure :
- non-sélective entre le troisième matériau et le deuxième matériau ;
- sélective du deuxième matériau par rapport au premier matériau ;
la gravure étant de préférence une gravure plasma.

Ainsi, un avantage procuré est de retirer efficacement les zones de la couche d'aplanissement, faisant face aux amas de matière, ainsi que les zones supérieures de la couche de protection s'étendant sur les amas de matière, de manière à exposer les amas de matière tout en gardant protégées les zones d'épitaxie sélective.

Selon une caractéristique de l'invention, l'étape a) est exécutée de sorte que les zones d'épitaxie sélective comportent des nanofils.

Ainsi, un avantage procuré est de pouvoir fabriquer ultérieurement des diodes électroluminescentes à nanofils.

Selon une caractéristique de l'invention, l'étape a) est exécutée de sorte que le premier matériau est un matériau semiconducteur, de préférence un matériau III-V.

Selon une caractéristique de l'invention, l'étape a) est exécutée de sorte que :
- le premier matériau est un matériau cristallin ;
- les amas de matière sont des cristallites du premier matériau.

Selon une caractéristique de l'invention, l'étape a) est exécutée de sorte que :
- les zones d'épitaxie sélective présentent une hauteur, notée h₁ ;
- les amas de matière présentent chacun une hauteur supérieure à 2 h₁, de préférence comprise entre 8 h₁ et 12 h₁.

Selon une caractéristique de l'invention, l'étape b) est exécutée de sorte que le deuxième matériau est un matériau solide, de préférence choisi parmi un matériau diélectrique et un matériau métallique.

Ainsi, un avantage procuré est de former un masque dur de gravure lors de l'étape g).

Selon une caractéristique de l'invention, le substrat prévu lors de l'étape a) est réalisé en silicium ; et l'étape b) est exécutée de sorte que le deuxième matériau est le dioxyde de silicium.

Selon une caractéristique de l'invention, la couche de protection est formée lors de l'étape b) par un dépôt conforme.

Ainsi, un avantage procuré est de suivre la topologie de surface du substrat.

Selon une caractéristique de l'invention, la couche d'aplanissement formée lors de l'étape c) est réalisée dans un polymère, de préférence un polymère photosensible.

Ainsi, un avantage procuré est d'obtenir une couche d'aplanissement à faible coût, d'épaisseur ajustable, pouvant être facilement déposée sur la couche de protection (e.g. par tournette).

Selon une caractéristique de l'invention, l'étape c) est exécutée par un dépôt à la tournette.

Selon une caractéristique de l'invention, l'étape g) est exécutée par une gravure plasma.

Selon une caractéristique de l'invention, l'étape h) est exécutée par une gravure chimique humide.

### Définitions

- Par « substrat », on entend un support physique autoporté, réalisé dans un matériau cristallin à partir duquel peut être formé par épitaxie un dispositif pour tout type d'applications, notamment électronique, mécanique, optique. Un substrat peut être une « tranche » (également dénommée « plaquette », « *wafer* » en langue anglaise) qui se présente généralement sous la forme d'un disque issu d'une découpe dans un lingot d'un matériau cristallin.
- Par « zones d'épitaxie sélective » (SAG pour « *Selective Area Growtb* » en langue anglaise), on entend des zones de la surface du substrat, localisées, qui ont subi une croissance épitaxiale, tandis que le reste de la surface du substrat n'a pas subi de croissance épitaxiale (par exemple à l'aide d'un masque de croissance). On parle également d'épitaxie à zone sélective. Les zones localisées de la surface du substrat forment un germe cristallin de croissance, à partir duquel peut croître le premier matériau cristallin. Lorsque le premier matériau est différent du matériau du substrat, on parle d'hétéroépitaxie. Lorsque le premier matériau est identique au matériau du substrat, on parle d'homoépitaxie.
- Par « couche de protection », on entend une couche adaptée pour protéger les zones d'épitaxie sélective en autorisant une gravure sélective :
   (i) du deuxième matériau par rapport au premier matériau lors de l'étape e) ou e'),
   (ii) du premier matériau par rapport au deuxième matériau lors de l'étape g).
- Par « couche d'aplanissement », on entend une couche adaptée pour obtenir une topographie de surface plane pour le substrat recouvert de la couche de protection. Par « plane », on entend une planéité dans les tolérances usuelles liées aux conditions expérimentales de fabrication, et non une planéité parfaite au sens mathématique du terme. Ainsi, une couche d'aplanissement s'étendant sur une structure de forte topographie sera légèrement ondulée (les angles seront adoucis et les différences de hauteur seront réduites) et non parfaitement plane.
- Par « exposer », on entend que les éléments exposés (zones supérieures de la couche de protection, amas de matière) présentent une surface libre.
- Par « gravure sélective d'un matériau A par rapport à un matériau B », on entend que le matériau A peut être gravé sans attaquer le matériau B. En pratique, l'agent de gravure est choisi de sorte que la vitesse de gravure du matériau A est au moins 2 fois supérieure (de préférence au moins 10 fois supérieure) à celle du matériau B.
- Par « semiconducteur », on entend que le matériau présente une conductivité électrique à 300 K comprise entre 10⁻⁶ S/cm et 10³ S/cm.
- Par « matériau III-V », on entend un alliage binaire entre des éléments situés respectivement dans la colonne III et dans la colonne V du tableau périodique des éléments.
- Par « hauteur », on entend une dimension suivant la normale à la surface du substrat.
- Par « diélectrique », on entend un matériau présentant une conductivité électrique à 300 K inférieure à 10⁻⁶ S/cm.
- Par « dépôt conforme », on entend une technique de dépôt (e.g. un dépôt physique en phase vapeur) de la couche de protection permettant de suivre la topologie de surface du substrat. Le taux de conformité (i.e. le ratio entre la largeur des flancs de la couche de protection déposée et l'épaisseur en surface de la couche de protection déposée) peut être compris entre 50% et 100%, de préférence compris entre 75% et 100%.

### Brève description des dessins

D'autres caractéristiques et avantages apparaîtront dans l'exposé détaillé de différents modes de réalisation de l'invention, l'exposé étant assorti d'exemples et de références aux dessins joints.
Figure 1 est une vue schématique en coupe, illustrant l'étape a) d'un procédé selon l'invention.
Figures 2a à 2f sont des vues schématiques en coupe, illustrant des étapes d'un premier procédé selon l'invention.
Figures 3a à 3f sont des vues schématiques en coupe, illustrant des étapes d'un deuxième procédé selon l'invention.

Il est à noter que les dessins décrits ci-avant sont schématiques, et ne sont pas nécessairement à l'échelle par souci de lisibilité et pour en simplifier leur compréhension. Les coupes sont effectuées suivant la normale à la surface du substrat.

### Exposé détaillé des modes de réalisation

Les éléments identiques ou assurant la même fonction porteront les mêmes références pour les différents modes de réalisation, par souci de simplification.

Un objet de l'invention est un procédé de traitement de surface, comportant les étapes :
a) prévoir un substrat 1 comportant une surface 10 présentant :
   - des zones d'épitaxie sélective 100 d'un premier matériau,
   - des amas de matière 101 du premier matériau, s'étendant entre les zones d'épitaxie sélective 100 ;
b) former une couche de protection 2, réalisée dans un deuxième matériau, sur la surface 10 du substrat 1 de manière à recouvrir les zones d'épitaxie sélective 100 et les amas de matière 101 ;
c) former une couche d'aplanissement 3 sur la couche de protection 2 ;
d) retirer des zones 3a de la couche d'aplanissement 3 faisant face aux amas de matière 101 de manière à exposer des zones supérieures 2a de la couche de protection 2 s'étendant sur les amas de matière 101 ;
e) graver, par une gravure chimique humide, les zones supérieures 2a exposées de la couche de protection 2 ainsi que des zones latérales 2b de la couche de protection 2 s'étendant en bordure des amas de matière 101, la gravure chimique humide étant exécutée par un agent de gravure autorisant une gravure sélective du deuxième matériau par rapport au premier matériau ;
f) retirer la couche d'aplanissement 3 ;
g) graver les amas de matière 101, la couche de protection 2 étant adaptée pour former un masque de gravure protégeant les zones d'épitaxie sélective 100 ;
h) retirer la couche de protection 2.

Un objet de l'invention est un procédé de traitement de surface, comportant les étapes :
a) prévoir un substrat 1 comportant une surface 10 présentant :
   - des zones d'épitaxie sélective 100 d'un premier matériau,
   - des amas de matière 101 du premier matériau, s'étendant entre les zones d'épitaxie sélective 100 ;
b) former une couche de protection 2, réalisée dans un deuxième matériau, sur la surface 10 du substrat 1 de manière à recouvrir les zones d'épitaxie sélective 100 et les amas de matière 101 ;
c) former une couche d'aplanissement 3 sur la couche de protection 2 ;
d') retirer des zones 3a de la couche d'aplanissement 3 faisant face aux amas de matière 101 ainsi que des zones supérieures 2a de la couche de protection 2 s'étendant sur les amas de matière 101, de manière à exposer les amas de matière 101 ;
e') graver, par une gravure chimique humide, des zones latérales 2b de la couche de protection 2 s'étendant en bordure des amas de matière 101 exposés, la gravure chimique humide étant exécutée par un agent de gravure autorisant une gravure sélective du deuxième matériau par rapport au premier matériau ;
f) retirer la couche d'aplanissement 3 ;
g) graver les amas de matière 101, la couche de protection 2 formant un masque de gravure protégeant les zones d'épitaxie sélective 100 ;
h) retirer la couche de protection 2.

### Etape a)

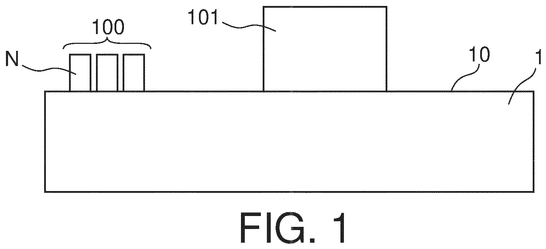

L'étape a) est illustrée à la figure 1.

L'étape a) peut être exécutée de sorte que les zones d'épitaxie sélective 100 comportent des nanofils N. Les zones d'épitaxie sélective 100 peuvent présenter une superficie de l'ordre de quelques mm². Les zones s'étendant entre les zones d'épitaxie sélective 100 peuvent présenter une superficie de l'ordre de quelques centaines de µm².

L'étape a) peut être exécutée de sorte que :
- le premier matériau est un matériau cristallin ;
- les amas de matière 101 sont des cristallites du premier matériau.

Les cristallites du premier matériau peuvent être de formes diverses : trapézoïdale, pyramidale, cylindrique etc.

L'étape a) peut être exécutée de sorte que le premier matériau est un matériau semiconducteur, de préférence un matériau III-V. A titre d'exemples non limitatifs, le premier matériau peut être le GaN ou l'InGaN.

L'étape a) peut être exécutée de sorte que :
- les zones d'épitaxie sélective 100 présentent une hauteur, notée h₁ ;
- les amas de matière 101 présentent chacun une hauteur supérieure à 2 h₁, de préférence comprise entre 8 h₁ et 12 h₁.

A titre d'exemple non limitatif, h₁ peut être de l'ordre de 1 µm et les amas de matière 101 peuvent présenter une hauteur de l'ordre de 10 µm.

Le substrat 1 prévu lors de l'étape a) peut être réalisé en silicium ou en saphir.

La surface 10 du substrat 1 peut être revêtue d'un masque de croissance (non illustré), excepté sur des zones de la surface 10 destinées à former les zones d'épitaxie sélective 100. Le cas échéant, après la croissance épitaxiale du premier matériau, les amas de matière 101 du premier matériau s'étendent sur le masque de croissance, entre les zones d'épitaxie sélective 100.

### Etape b)

Le deuxième matériau est différent du premier matériau.

L'étape b) est avantageusement exécutée de sorte que le deuxième matériau est un matériau solide, de préférence choisi parmi un matériau diélectrique et un matériau métallique (tel que le platine). Lorsque le substrat 1 prévu lors de l'étape a) est réalisé en silicium ou en saphir, l'étape b) est avantageusement exécutée de sorte que le deuxième matériau est le dioxyde de silicium.

La couche de protection 2 est avantageusement formée lors de l'étape b) par un dépôt conforme, par exemple par un dépôt chimique en phase vapeur assisté par plasma PECVD (« *Plasma-Enhanced Chemical Vapor Deposition* » en langue anglaise). La couche de protection 2 peut présenter une épaisseur de 2 µm. A titre d'exemple non limitatif, la couche de protection 2 peut être déposée par un dépôt physique en phase vapeur.

En présence d'un masque de croissance, l'étape b) est exécutée de manière à recouvrir également le masque de croissance.

### Etape c)

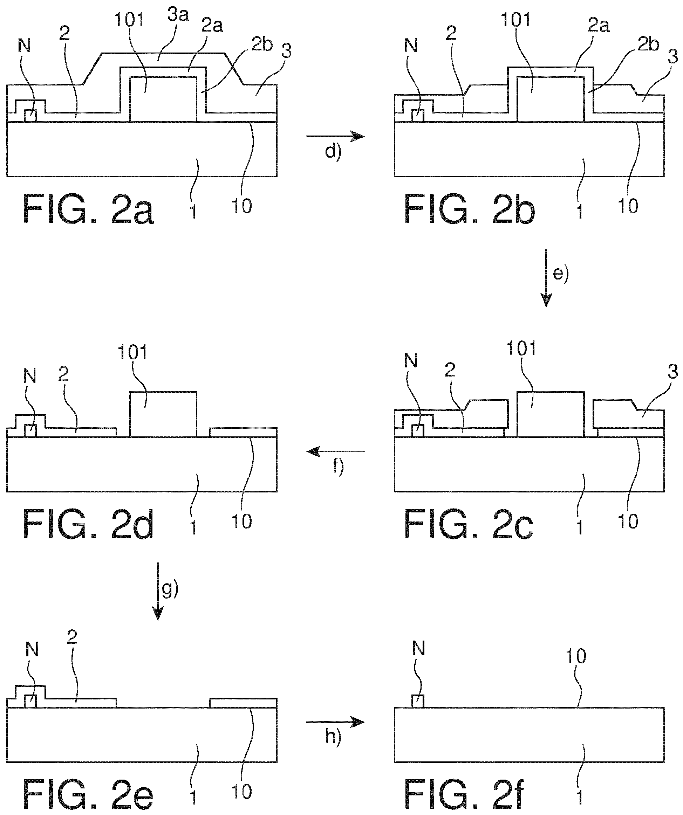

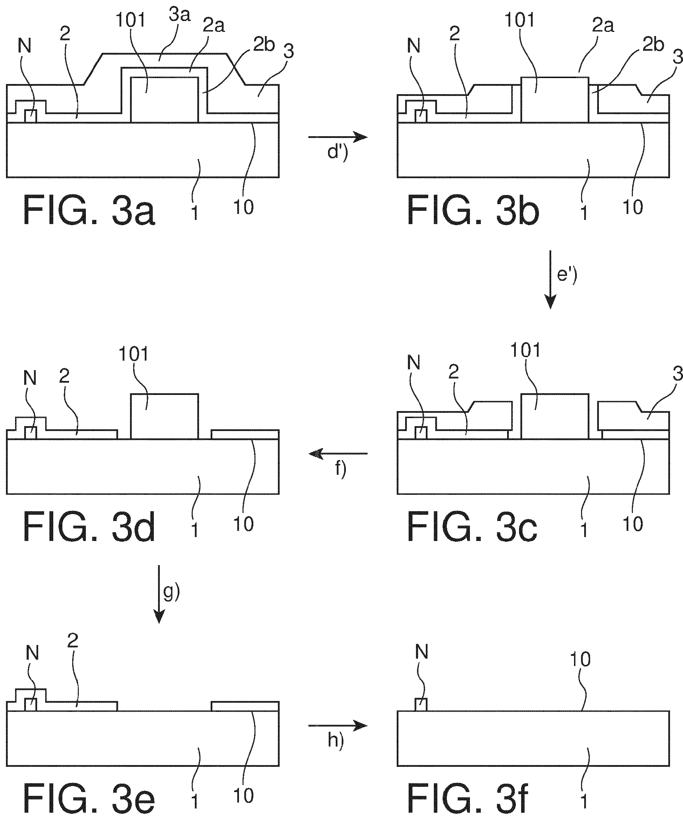

La situation à l'issue de l'étape c) est illustrée aux figures 2a et 3a.

La couche d'aplanissement 3 formée lors de l'étape c) est réalisée dans un troisième matériau. Le troisième matériau est différent des premier et deuxième matériaux. La couche d'aplanissement 3 formée lors de l'étape c) est avantageusement réalisée dans un polymère, de préférence un polymère photosensible (résine de photolithographie). Le cas échéant, l'étape c) est avantageusement exécutée par un dépôt à la tournette.

### Etape d)

L'étape d) est illustrée à la figure 2b.

L'étape d) peut être exécutée par un amincissement de la couche d'aplanissement 3, tout en gardant protégées les zones d'épitaxie sélective 100.

L'étape d) est avantageusement exécutée par une gravure sélective, par exemple de type pleine plaque (i.e. une gravure pas seulement localisée en face des amas de matière 101), du troisième matériau par rapport au deuxième matériau, la gravure étant de préférence une gravure plasma.

Lorsque le premier matériau est le GaN, le deuxième matériau est le SiO₂, et le troisième matériau est une résine photosensible, l'étape d) peut être exécutée par une gravure plasma (e.g. gravure ionique réactive RIE avec un plasma à couplage inductif ICP) à base de O₂.

### Etape d')

L'étape d') est illustrée à la figure 3b.

L'étape d') peut être exécutée par un amincissement de la couche d'aplanissement 3, tout en gardant protégées les zones d'épitaxie sélective 100.

L'étape d') est avantageusement exécutée par une gravure :
- non-sélective entre le troisième matériau et le deuxième matériau ;
- sélective du deuxième matériau par rapport au premier matériau ;
la gravure étant de préférence une gravure plasma. La gravure peut être de type pleine plaque, c'est-à-dire une gravure pas seulement localisée en face des amas de matière 101.

Lorsque le premier matériau est le GaN, le deuxième matériau est le SiO₂, et le troisième matériau est une résine photosensible, l'étape d') peut être exécutée par une gravure plasma (e.g. gravure ionique réactive RIE avec un plasma à couplage inductif ICP) à base de CHF₃/O₂.

### Etape e)

L'étape e) est illustrée à la figure 2c.

L'agent de gravure par lequel est exécutée l'étape e) peut comporter une solution d'acide fluorhydrique. L'agent de gravure peut être une solution d'acide fluorhydrique tamponné BOE (pour *«Buffered Oxide Etch* » en langue anglaise), par exemple lorsque la couche de protection 2 est réalisée en SiO₂.

### Etape e')

L'étape e') est illustrée à la figure 3c.

L'agent de gravure par lequel est exécutée l'étape e') peut comporter une solution d'acide fluorhydrique. L'agent de gravure peut être une solution d'acide fluorhydrique tamponné BOE (pour «*Buffered Oxide Etch* » en langue anglaise), par exemple lorsque la couche de protection 2 est réalisée en SiO₂.

### Etape f)

L'étape f) est illustrée aux figures 2d et 3d.

Lorsque la couche d'aplanissement 3 est réalisée dans une résine, l'étape f) peut être exécutée par une technique de retrait de résine (« *stripping* » en langue anglaise), par exemple à l'aide d'acétone.

### Etape g)

L'étape g) est illustrée aux figures 2e et 3e.

La gravure de l'étape g) est une gravure sélective du premier matériau par rapport au deuxième matériau. L'étape g) est avantageusement exécutée par une gravure plasma. Lorsque le premier matériau est le GaN, et le deuxième matériau est le SiO₂, l'étape g) peut être exécutée par une gravure plasma (e.g. gravure ionique réactive RIE avec un plasma à couplage inductif ICP) à base de Cl₂.

### Etape h)

L'étape h) est illustrée aux figures 2f et 3f.

L'étape h) peut être une gravure sélective du deuxième matériau par rapport au premier matériau. L'étape h) est avantageusement exécutée par une gravure chimique humide, par exemple à l'aide d'une solution d'acide fluorhydrique lorsque le premier matériau est le GaN et le deuxième matériau est le SiO₂.

## Revendications

1. Procédé de traitement de surface, comportant les étapes :
a) prévoir un substrat (1) comportant une surface (10) présentant :
- des zones d'épitaxie sélective (100) d'un premier matériau,
- des amas de matière (101) du premier matériau, s'étendant entre les zones d'épitaxie sélective (100) ;
b) former une couche de protection (2), réalisée dans un deuxième matériau, sur la surface (10) du substrat (1) de manière à recouvrir les zones d'épitaxie sélective (100) et les amas de matière (101) ;
c) former une couche d'aplanissement (3) sur la couche de protection (2) ;
d) retirer des zones (3a) de la couche d'aplanissement (3) faisant face aux amas de matière (101) de manière à exposer des zones supérieures (2a) de la couche de protection (2) s'étendant sur les amas de matière (101) ;
e) graver, par une gravure chimique humide, les zones supérieures (2a) exposées de la couche de protection (2) ainsi que des zones latérales (2b) de la couche de protection (2) s'étendant en bordure des amas de matière (101), la gravure chimique humide étant exécutée par un agent de gravure autorisant une gravure sélective du deuxième matériau par rapport au premier matériau ;
f) retirer la couche d'aplanissement (3) ;
g) graver les amas de matière (101), la couche de protection (2) étant adaptée pour former un masque de gravure protégeant les zones d'épitaxie sélective (100) ;
h) retirer la couche de protection (2).

2. Procédé de traitement de surface, comportant les étapes :
a) prévoir un substrat (1) comportant une surface (10) présentant :
- des zones d'épitaxie sélective (100) d'un premier matériau,
- des amas de matière (101) du premier matériau, s'étendant entre les zones d'épitaxie sélective (100) ;
b) former une couche de protection (2), réalisée dans un deuxième matériau, sur la surface (10) du substrat (1) de manière à recouvrir les zones d'épitaxie sélective (100) et les amas de matière (101) ;
c) former une couche d'aplanissement (3) sur la couche de protection (2) ;
d') retirer des zones (3a) de la couche d'aplanissement (3) faisant face aux amas de matière (101) ainsi que des zones supérieures (2a) de la couche de protection (2) s'étendant sur les amas de matière (101), de manière à exposer les amas de matière (101) ;
e') graver, par une gravure chimique humide, des zones latérales (2b) de la couche de protection (2) s'étendant en bordure des amas de matière (101) exposés, la gravure chimique humide étant exécutée par un agent de gravure autorisant une gravure sélective du deuxième matériau par rapport au premier matériau ;
f) retirer la couche d'aplanissement (3) ;
g) graver les amas de matière (101), la couche de protection (2) formant un masque de gravure protégeant les zones d'épitaxie sélective (100) ;
h) retirer la couche de protection (2).

3. Procédé selon la revendication 1, dans lequel la couche d'aplanissement (3) est réalisée dans un troisième matériau ; et l'étape d) est exécutée par une gravure sélective du troisième matériau par rapport au deuxième matériau, la gravure étant de préférence une gravure plasma.

4. Procédé selon la revendication 2, dans lequel la couche d'aplanissement (3) est réalisée dans un troisième matériau ; et l'étape d') est exécutée par une gravure :
- non-sélective entre le troisième matériau et le deuxième matériau ;
- sélective du deuxième matériau par rapport au premier matériau ;
la gravure étant de préférence une gravure plasma.

5. Procédé selon l'une des revendications 1 à 4, dans lequel l'étape a) est exécutée de sorte que les zones d'épitaxie sélective (100) comportent des nanofils (N).

6. Procédé selon l'une des revendications 1 à 5, dans lequel l'étape a) est exécutée de sorte que le premier matériau est un matériau semiconducteur, de préférence un matériau III-V.

7. Procédé selon l'une des revendications 1 à 6, dans lequel l'étape a) est exécutée de sorte que :
- le premier matériau est un matériau cristallin ;
- les amas de matière (101) sont des cristallites du premier matériau.

8. Procédé selon l'une des revendications 1 à 7, dans lequel l'étape a) est exécutée de sorte que :
- les zones d'épitaxie sélective (100) présentent une hauteur, notée h₁ ;
- les amas de matière (101) présentent chacun une hauteur supérieure à 2 h₁, de préférence comprise entre 8 h₁ et 12 h₁.

9. Procédé selon l'une des revendications 1 à 8, dans lequel l'étape b) est exécutée de sorte que le deuxième matériau est un matériau solide, de préférence choisi parmi un matériau diélectrique et un matériau métallique.

10. Procédé selon l'une des revendications 1 à 9, dans lequel le substrat (1) prévu lors de l'étape a) est réalisé en silicium ; et l'étape b) est exécutée de sorte que le deuxième matériau est le dioxyde de silicium.

11. Procédé selon l'une des revendications 1 à 10, dans lequel la couche de protection (2) est formée lors de l'étape b) par un dépôt conforme.

12. Procédé selon l'une des revendications 1 à 11, dans lequel la couche d'aplanissement (3) formée lors de l'étape c) est réalisée dans un polymère, de préférence un polymère photosensible.

13. Procédé selon la revendication 12, dans lequel l'étape c) est exécutée par un dépôt à la tournette.

14. Procédé selon l'une des revendications 1 à 13, dans lequel l'étape g) est exécutée par une gravure plasma.

15. Procédé selon l'une des revendications 1 à 14, dans lequel l'étape h) est exécutée par une gravure chimique humide.

## Patentansprüche

1. Oberflächenbehandlungsverfahren, umfassend die Schritte:
a) Bereitstellen eines Substrats (1), das eine Oberfläche (10) umfasst, die aufweist:
- Bereiche mit selektiver Epitaxie (100) eines ersten Materials,
- Stoffanhäufungen (101) des ersten Materials, die sich zwischen den Bereichen mit selektiver Epitaxie (100) erstrecken;
b) Bilden einer Schutzschicht (2), die aus einem zweiten Material ausgeführt ist, auf der Oberfläche (10) des Substrats (1), so dass die Bereiche mit selektiver Epitaxie (100) und die Stoffanhäufungen (101) bedeckt werden;
c) Bilden einer Planarisierungsschicht (3) auf der Schutzschicht (2);
d) Entfernen der Bereiche (3a) der Planarisierungsschicht (3) gegenüber den Stoffanhäufungen (101), so dass obere Bereiche (2a) der Schutzschicht (2), die sich auf den Stoffanhäufungen (101) erstrecken, freigelegt werden;
e) Ätzen, durch ein chemisches Nassätzen, der freigelegten oberen Bereiche (2a) der Schutzschicht (2) sowie von seitlichen Bereichen (2b) der Schutzschicht (2), die sich am Rand der Stoffanhäufungen (101) erstrecken, wobei das chemische Nassätzen durch ein Ätzmittel durchgeführt wird, das ein selektives Ätzen des zweiten Materials in Bezug auf das erste Material zulässt;
f) Entfernen der Planarisierungsschicht (3);
g) Ätzen der Stoffanhäufungen (101), wobei die Schutzschicht (2) dazu angepasst ist, eine Ätzmaske zu bilden, die die Bereiche mit selektiver Epitaxie (100) schützt;
h) Entfernen der Schutzschicht (2).

2. Oberflächenbehandlungsverfahren, umfassend die Schritte:
a) Bereitstellen eines Substrats (1), das eine Oberfläche (10) umfasst, die aufweist:
- Bereiche mit selektiver Epitaxie (100) eines ersten Materials,
- Stoffanhäufungen (101) des ersten Materials, die sich zwischen den Bereichen mit selektiver Epitaxie (100) erstrecken;
b) Bilden einer Schutzschicht (2), die aus einem zweiten Material ausgeführt ist, auf der Oberfläche (10) des Substrats (1), so dass die Bereiche mit selektiver Epitaxie (100) und die Stoffanhäufungen (101) bedeckt werden;
c) Bilden einer Planarisierungsschicht (3) auf der Schutzschicht (2);
d') Entfernen der Bereiche (3a) der Planarisierungsschicht (3) gegenüber den Stoffanhäufungen (101) sowie der oberen Bereiche (2a) der Schutzschicht (2), die sich auf den Stoffanhäufungen (101) erstrecken, so dass die Stoffanhäufungen (101) freigelegt werden;
e') Ätzen, durch ein chemisches Nassätzen, der seitlichen Bereiche (2b) der Schutzschicht (2), die sich am Rand der freigelegten Stoffanhäufungen (101) erstrecken, wobei das chemische Nassätzen durch ein Ätzmittel durchgeführt wird, das ein selektives Ätzen des zweiten Materials in Bezug auf das erste Material zulässt;
f) Entfernen der Planarisierungsschicht (3);
g) Ätzen der Stoffanhäufungen (101), wobei die Schutzschicht (2) eine Ätzmaske bildet, die die Bereiche mit selektiver Epitaxie (100) schützt;
h) Entfernen der Schutzschicht (2).

3. Verfahren nach Anspruch 1, wobei die Planarisierungsschicht (3) aus einem dritten Material ausgeführt ist; und der Schritt d) durch ein selektives Ätzen des dritten Materials in Bezug auf das zweite Material durchgeführt wird, wobei das Ätzen bevorzugt ein Plasmaätzen ist.

4. Verfahren nach Anspruch 2, wobei die Planarisierungsschicht (3) aus einem dritten Material ausgeführt ist; und der Schritt d') durchgeführt wird durch ein:
- nicht-selektives Ätzen zwischen dem dritten Material und dem zweiten Material;
- selektives Ätzen des zweiten Materials in Bezug auf das erste Material;
wobei das Ätzen bevorzugt ein Plasmaätzen ist.

5. Verfahren nach einem der Ansprüche 1 bis 4, wobei der Schritt a) so durchgeführt wird, dass die Bereiche mit selektiver Epitaxie (100) Nanodrähte (N) umfassen.

6. Verfahren nach einem der Ansprüche 1 bis 5, wobei der Schritt a) so durchgeführt wird, dass das erste Material ein Halbleitermaterial ist, bevorzugt ein III-V-Material.

7. Verfahren nach einem der Ansprüche 1 bis 6, wobei der Schritt a) so durchgeführt wird, dass:
- das erste Material ein kristallines Material ist;
- die Stoffanhäufungen (101) Kristallite des ersten Materials sind.

8. Verfahren nach einem der Ansprüche 1 bis 7, wobei der Schritt a) so durchgeführt wird, dass:
- die Bereiche mit selektiver Epitaxie (100) eine mit h₁ bezeichnete Höhe aufweisen;
- die Stoffanhäufungen (101) jeweils eine Höhe aufweisen, die größer als 2 h₁ ist, bevorzugt zwischen 8 h₁ und 12 h₁ beträgt.

9. Verfahren nach einem der Ansprüche 1 bis 8, wobei der Schritt b) so durchgeführt wird, dass das zweite Material ein festes Material ist, das bevorzugt aus einem dielektrischen Material und einem metallischen Material ausgewählt ist.

10. Verfahren nach einem der Ansprüche 1 bis 9, wobei das bei dem Schritt a) bereitgestellte Substrat (1) aus Silicium ausgeführt ist; und wobei der Schritt b) so durchgeführt wird, dass das zweite Material Siliciumdioxid ist.

11. Verfahren nach einem der Ansprüche 1 bis 10, wobei die Schutzschicht (2) bei dem Schritt b) durch ein konformes Abscheiden gebildet wird.

12. Verfahren nach einem der Ansprüche 1 bis 11, wobei die bei dem Schritt c) gebildete Planarisierungsschicht (3) aus einem Polymer, bevorzugt einem lichtempfindlichen Polymer, ausgeführt ist.

13. Verfahren nach Anspruch 12, wobei der Schritt c) durch ein Abscheiden mit dem Rotationsbeschichter durchgeführt wird.

14. Verfahren nach einem der Ansprüche 1 bis 13, wobei der Schritt g) durch ein Plasmaätzen durchgeführt wird.

15. Verfahren nach einem der Ansprüche 1 bis 14, wobei der Schritt h) durch ein chemisches Nassätzen durchgeführt wird.

## Claims

1. Surface treatment method, comprising the steps of:
a) providing a substrate (1) comprising a surface (10) having:
- areas of selective epitaxy (100) of a first material,
- masses of matter (101) of the first material, extending between the areas of selective epitaxy (100);
b) forming a protection layer (2), produced in a second material, on the surface (10) of the substrate (1) so as to cover the areas of selective epitaxy (100) and the masses of matter (101);
c) forming a flattening layer (3) on the protection layer (2);
d) removing areas (3a) of the flattening layer (3) facing the masses of matter (101) so as to expose top areas (2a) of the protection layer (2) extending over the masses of matter (101);
e) etching, by a wet chemical etching, the exposed top areas (2a) of the protection layer (2) and lateral areas (2b) of the protection layer (2) extending at the border of the masses of matter (101), the wet chemical etching being executed by an etching agent allowing a selective etching of the second material with respect to the first material;
f) removing the flattening layer (3);
g) etching the masses of matter (101), the protection layer (2) being adapted to form an etch mask protecting the areas of selective epitaxy (100);
h) removing the protection layer (2).

2. Surface treatment method, comprising the steps of:
a) providing a substrate (1) comprising a surface (10) having:
- areas of selective epitaxy (100) of a first material,
- masses of matter (101) of the first material, extending between the areas of selective epitaxy (100);
b) forming a protection layer (2), produced in a second material, on the surface (10) of the substrate (1) so as to cover the areas of selective epitaxy (100) and the masses of matter (101);
c) forming a flattening layer (3) on the protection layer (2);
d') removing areas (3a) of the flattening layer (3) facing the masses of matter (101) and top areas (2a) of the protection layer (2) extending over the masses of matter (101), so as to expose the masses of matter (101);
e') etching, by a wet chemical etching, lateral areas (2b) of the protection layer (2) extending at the border of the exposed masses of matter (101), the wet chemical etching being executed by an etching agent allowing a selective etching of the second material with respect to the first material;
f) removing the flattening layer (3);
g) etching the masses of matter (101), the protection layer (2) forming an etch mask protecting the areas of selective epitaxy (100);
h) removing the protection layer (2).

3. Method according to Claim 1, wherein the flattening layer (3) is produced in a third material; and the step d) is executed by a selective etching of the third material with respect to the second material, the etching being preferably a plasma etching.

4. Method according to Claim 2, wherein the flattening layer (3) is produced in a third material; and the step d') is executed by an etching:
- that is non-selective between the third material and the second material;
- that is selective of the second material with respect to the first material;
the etching being preferably a plasma etching.

5. Method according to one of Claims 1 to 4, wherein the step a) is executed such that the areas of selective epitaxy (100) comprise nanowires (N).

6. Method according to one of Claims 1 to 5, wherein the step a) is executed such that the first material is a semiconductor material, preferably a III-V material.

7. Method according to one of Claims 1 to 6, wherein the step a) is executed such that:
- the first material is a crystalline material;
- the masses of matter (101) are crystallites of the first material.

8. Method according to one of Claims 1 to 7, wherein the step a) is executed such that:
- the areas of selective epitaxy (100) have a height, denoted h₁;
- the masses of matter (101) each have a height greater than 2 h₁, preferably lying between 8 h₁ and 12 h₁.

9. Method according to one of Claims 1 to 8, wherein the step b) is executed such that the second material is a solid material, preferably chosen from among a dielectric material and a metallic material.

10. Method according to one of Claims 1 to 9, wherein the substrate (1) provided in the step a) is produced in silicon; and the step b) is executed such that the second material is silicon dioxide.

11. Method according to one of Claims 1 to 10, wherein the protection layer (2) is formed in the step b) by a conformal deposition.

12. Method according to one of Claims 1 to 11, wherein the flattening layer (3) formed in the step c) is produced in a polymer, preferably a photosensitive polymer.

13. Method according to Claim 12, wherein the step c) is executed by a deposition by spinner.

14. Method according to one of Claims 1 to 13, wherein the step g) is executed by a plasma etching.

15. Method according to one of Claims 1 to 14, wherein the step h) is executed by a wet chemical etching.
